# EUROPEAN PATENT APPLICATION

(11) **EP 4 557 108 A1**
(43) Date of publication of application: **21.05.2025**
(21) Application number: 24213158.9
(22) Date of filing: 15.11.2024
(51) Int. Cl.: G06F 12/02

(54) **STORAGE DEVICE, OPERATING METHOD THEREOF AND MEMORY CONTROLLER**

(30) Priority: 15.11.2023 KR 20230158289
(71) Applicant: SK Hynix Inc., Icheon-si, Gyeonggi-do 17336 (KR)
(72) Inventor: CHOI, Jung Sik, 17336 Icheon-si, Gyeonggi-do (KR)
(74) Representative: Isarpatent

(57) **Abstract**

The present application relates to a storage device, an operating method thereof and a memory controller. The storage device may include a memory device and a memory controller. The memory device may include a plurality of physical pages. The memory controller may group the plurality of physical pages into a plurality of stress physical page groups according to a stress level of each of the plurality of physical pages, the stress level associated with read disturb, and perform a garbage collection operation on each of the plurality of stress physical page groups, based on the stress level.

## Description

### CROSS-REFERENCE TO RELATED APPLICATION

The present application claims priority under 35 U.S.C. § 119(a) to Korean patent application number 10-2023-0158289 filed on November 15, 2023, the entire disclosure of which is incorporated by reference herein.

### BACKGROUND

### 1. Field of Invention

Embodiments of the present disclosure generally relate to an electronic device, and more particularly, to a storage device and an operating method thereof.

### 2. Description of Related Art

A storage device is a device which stores data under the control of a host device such as a computer or a smartphone. The storage device may include a memory device in which data is stored and a memory controller which controls the memory device. The memory device is classified into a volatile memory device and a nonvolatile memory device.

To improve the reliability of the memory device and increase the lifetime of the memory device, the memory controller may perform a garbage collection operation of moving valid data stored in a memory block to another memory block when a number of detected fail bits exceeds a reference value as a result of a test read operation on the memory block.

### SUMMARY

Embodiments of the present disclosure provide a storage device and an operating method thereof, in which a test read operation is performed on only a physical page group weak to read disturb in a memory block, and a partial garbage collection operation is performed on the physical page group according to a result of the test read operation.

In accordance with an embodiment of the present disclosure, there is provided a storage device including: a memory device including a memory block including a plurality of physical pages; and a memory controller configured to group the plurality of physical pages into a plurality of stress physical page groups according to a stress level of each of the plurality of physical pages, the stress level associated with read disturb, and perform a garbage collection operation on each of the plurality of stress physical page groups, based on the stress level.

In accordance with another embodiment of the present disclosure, there is provided a method of operating a storage device, the method including: grouping a plurality of physical pages included in a memory block of a memory device of the storage device into a plurality of stress physical page groups according to a stress level of each of the plurality of physical pages, the stress level associated with read disturb; selecting a target stress physical page group among the plurality of stress physical page groups, based on the stress level; performing a first garbage collection operation on the target stress physical page group; receiving, from a host, an access request of a host after the first garbage collection operation is performed, the access request being for the other stress physical page group different from the target stress physical page group among the plurality of stress physical page groups; and performing a second garbage collection operation on the other stress physical page group after a response to the access request is transmitted to the host.

In accordance with still another embodiment of the present disclosure, there is provided a memory controller including: a stress information storage configured to store stress information on a plurality of stress physical page groups obtained by grouping a plurality of physical pages included in a memory block according to a stress level of each of the plurality of physical pages, the stress level associated with read disturb; a read controller configured to perform a test read operation on at least one weak physical page in a target stress physical page group among the plurality of stress physical page groups; and a garbage controller configured to perform a garbage collection operation on each of the plurality of stress physical page groups, based on the stress level.

### BRIEF DESCRIPTION OF THE DRAWINGS

Various embodiments of the present disclosure will now be described more fully hereinafter with reference to the accompanying drawings; however, the embodiments may be embodied in different forms and should not be construed as limited to the embodiments set forth herein. Rather, these embodiments are provided so that this disclosure will be thorough and complete, and will fully convey the scope of the embodiments to those skilled in the art.

In the drawing figures, dimensions may be exaggerated for clarity of illustration. It will be understood that when an element is referred to as being "between" two elements, it can be the only element between the two elements, or one or more intervening elements may also be present. Like reference numerals refer to like elements throughout.
FIG. 1 is a diagram illustrating a storage device in accordance with an embodiment of the present disclosure.
FIG. 2 is a diagram illustrating a memory device in accordance with an embodiment of the present disclosure.
FIG. 3 is a diagram illustrating a memory block and positions of word lines in accordance with an embodiment of the present disclosure.
FIG. 4 is a diagram illustrating a stress physical page group and stress information in accordance with an embodiment of the present disclosure.
FIG. 5 is a diagram illustrating an accessible period for each stress physical page group.
FIG. 6A is a diagram illustrating a full garbage collection operation and a partial garbage collection operation in accordance with an embodiment of the present disclosure.
FIG. 6B is a diagram illustrating a map update in the partial garbage collection operation in accordance with an embodiment of the present disclosure.
FIG. 6C is a diagram illustrating stress physical page groups on which test read is performed and an order in which the test read is performed.
FIG. 7 is a diagram illustrating a test read performance time in accordance with an embodiment of the present disclosure.
FIG. 8 is a flowchart illustrating an operation of the storage device in accordance with an embodiment of the present disclosure.
FIG. 9 is a flowchart illustrating an operation of the storage device in accordance with an embodiment of the present disclosure.
FIG. 10 is a flowchart illustrating an operation of the storage device in accordance with an embodiment of the present disclosure.
FIG. 11 is a flowchart illustrating an operation of the storage device in accordance with an embodiment of the present disclosure.
FIG. 12 is a diagram illustrating another embodiment of a memory controller shown in FIG. 1.

### DETAILED DESCRIPTION

The specific structural or functional description disclosed herein is merely illustrative for the purpose of describing embodiments according to the concept of the present disclosure. The embodiments according to the concept of the present disclosure can be implemented in various forms, and should not be construed as limited to the embodiments set forth herein.

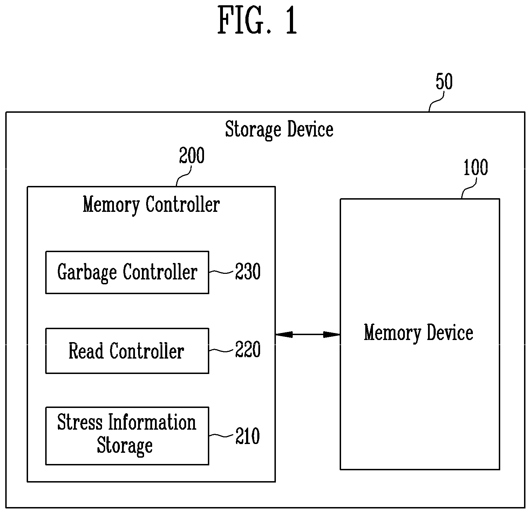

FIG. 1 is a diagram illustrating a storage device 50 in accordance with an embodiment of the present disclosure.

Referring to FIG. 1, the storage device 50 may include a memory device 100 and a memory controller 200 which controls an operation of the memory device 100. The storage device 50 may be a device which stores data under the control of a host.

The storage device 50 may be manufactured as any of various types of storage devices according to a communication scheme with the host. For example, the storage device 50 may be configured as any one of storage devices, such as an SSD, a multimedia card in the form of an MMC and an eMMC, a Universal Serial Bus (USB) storage device, a Universal Flash Storage (UFS) device, a peripheral component interconnection (PCI) card type storage device, a PCI express (PCI-e or PCIe) card type storage device, a Compact Flash (CF) card, a Smart Media Card (SMC), and a memory stick.

The storage device 50 may be manufactured as any of various package types. For example, the storage device 50 may be manufactured as any of various package types such as a Package-On-Package (POP), a System-In-Package (SIP), a System-On-Chip (SOC), a Multi-Chip Package (MCP), a Chip-On-Board (COB), a Wafer-level Fabricated Package (WFP), and a Wafer-level Stack Package (WSP).

The memory device 100 may store data. The memory device 100 may operate under the control of the memory controller 200. The memory device 100 may include a plurality of memory blocks. A memory block may include a plurality of memory cells for storing data. Memory cells connected to the same word line may constitute one physical page. The memory block may include a plurality of physical page groups. Each of the plurality of physical page groups may include at least one physical page.

In an embodiment, the memory device 100 may include a volatile memory and a nonvolatile memory.

The memory device 100 may receive a command and an address from the memory controller 200, and access a region selected by the address in a storage region. That is, the memory device 100 may perform an operation instructed by the command on the region selected by the address. For example, the memory device 100 may perform a write operation (program operation), a read operation, and an erase operation. In the program operation, the memory device 100 may program data in the region selected by the address. In the read operation, the memory device 100 may read data stored in the region selected by the address. In the erase operation, the memory device 100 may erase data stored in the region selected by the address.

The memory controller 200 may control overall operations of the storage device 50.

In an embodiment, the memory controller 200 may receive data and a logical address, which are input from the host, and translate the logical address into a physical address representing addresses of memory cells included in the memory device 100, in which data is to be stored.

The memory controller 200 may control the memory device 100 to perform a program operation, a read operation, an erase operation, or the like in response to a request from the host. In the program operation, the memory controller 200 may provide to the memory device 100 a program command, a physical address, and data. In the read operation, the memory controller 200 may provide to the memory device 100 a read command and a physical address. In the erase operation, the memory controller 200 may provide to the memory device 100 an erase command and a physical address.

In an embodiment, the memory controller 200 may include a stress information storage 210, a read controller 220, and a garbage controller 230.

The stress information storage 210 may store stress information on a plurality of stress physical page groups obtained by grouping a plurality of physical pages included in a memory block according to a stress level of each of the plurality of physical pages weak to read disturb. A stress level may be predetermined through a test in a manufacturing process of the memory device 100. The determined stress level may be set in firmware. The stress level may be determined based on the physical position of a physical page in the memory block.

The read controller 220 may perform a test read operation on at least one weak physical page in a target stress physical page group among the plurality of stress physical page groups. The read controller 220 may perform a test read operation whenever a read count of the memory block reaches a predetermined test read count. Specifically, the read controller 220 may perform a test read operation on a stress physical page group included in the memory block, based on the stress information, and detect a fail bit from a result of the test read operation. The read controller 220 may individually perform a test read operation on the plurality of stress physical page groups in an order in which the stress level is high.

The garbage controller 230 may perform a garbage collection operation on each of the plurality of stress physical page groups in an order in which the stress level is high. The garbage collection operation may be a partial garbage collection operation of moving, to another storage area, only valid data stored in the target stress physical page group instead of all valid data stored in the memory block.

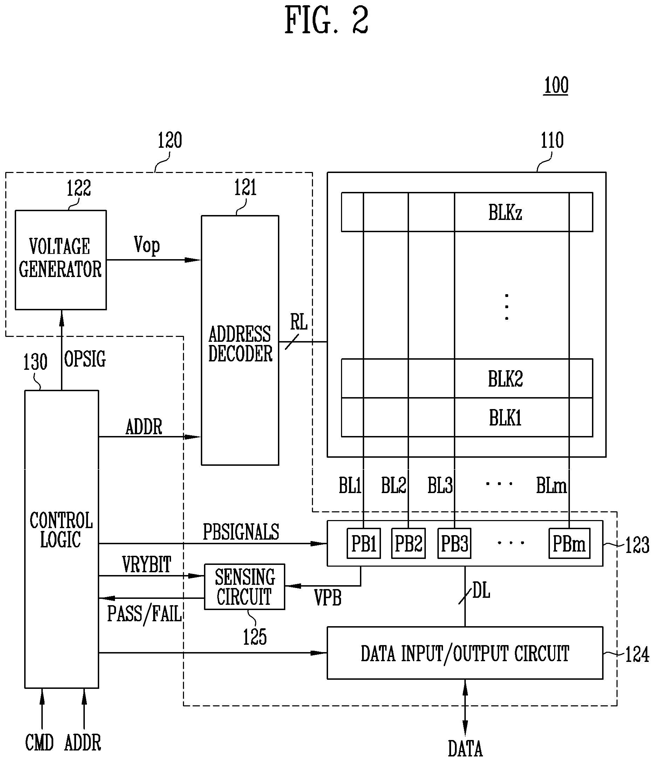

FIG. 2 is a diagram illustrating a memory device 100 in accordance with an embodiment of the present disclosure.

Referring to FIG. 2, the memory device 100 may include a memory cell array 110, a peripheral circuit 120, and a control logic 130.

The memory cell array 110 may include a plurality of memory blocks BLK1 to BLKz. The plurality of memory blocks BLK1 to BLKz may be connected to an address decoder 121 through row lines RL. The plurality of memory blocks BLK1 to BLKz may be connected to a read and write (read/write) circuit 123 through bit lines BL1 to BLm. Each of the plurality of memory blocks BLK1 to BLKz may include a plurality of memory cells. In an embodiment, the plurality of memory cells may be nonvolatile memory cells.

Each of the memory cells of the memory device 100 may be configured as a Single Level Cell (SLC) storing one-bit data, a Multi-Level Cell (MLC) storing two-bit data, a Triple Level Cell (TLC) storing three-bit data, or a Quad Level Cell (QLC) storing four-bit data.

The peripheral circuit 120 may include the address decoder 121, a voltage generator 122, the read/write circuit 123, a data input and output (input/output) circuit 124, and a sensing circuit 125.

The peripheral circuit 120 may drive the memory cell array 110. For example, the peripheral circuit 120 may drive the memory cell array 110 to perform a program operation, a read operation, and an erase operation.

The address decoder 121 may be connected to the memory cell array 110 through the row lines RL. The row lines RL may include drain select lines, word lines, source select lines, and a common source line.

The address decoder 121 may operate under the control of the control logic 130. The address decoder 121 may receive an address ADDR from the control logic 130.

The address decoder 121 may decode a block address in the received address ADDR. The address decoder 121 may select at least one memory block among the memory blocks BLK1 to BLKz according to the decoded block address. The address decoder 121 may decode a row address in the received address ADDR. The address decoder 121 may select at least one word line among word lines of the selected memory block according to the decoded row address. The address decoder 121 may apply to the selected word line an operating voltage Vop supplied from the voltage generator 122.

In a program operation, the address decoder 121 may apply a program voltage to the selected word line, and apply to unselected word lines a pass voltage having a level lower than a level of the program voltage. In a program verify operation, the address decoder 121 may apply a verify voltage to the selected word line, and apply to the unselected word lines a verify pass voltage having a level higher than a level of the verify voltage. In a read operation, the address decoder 121 may apply a read voltage to the selected word line, and apply to the unselected word lines a read pass voltage having a level higher than a level of the read voltage. In an erase operation, the address decoder 121 may apply a ground voltage to the word lines of the selected memory block.

In accordance with an embodiment of the present disclosure, an erase operation of the memory device 100 may be performed in units of memory blocks. An address ADDR input to the memory device 100 in the erase operation may include a block address.

In accordance with an embodiment of the present disclosure, the address decoder 121 may decode a column address in the received address ADDR. The decoded column address may be transferred to the read/write circuit 123. The address decoder 121 may include components such as a row decoder, a column decoder, and an address buffer.

The voltage generator 122 may generate a plurality of operating voltages Vop by using an external power voltage supplied to the memory device 100. The voltage generator 122 may operate under the control of the control logic 130.

In an embodiment, the voltage generator 122 may generate an internal power voltage by regulating the external power voltage. The internal power voltage generated by the voltage generator 122 may be used as an operating voltage of the memory device 100.

In an embodiment, the voltage generator 122 may generate a plurality of operating voltages Vop by using the external power voltage or the internal power voltage. The voltage generator 122 may generate various voltages required in the memory device 100. For example, the voltage generator 122 may generate a plurality of erase voltages, a plurality of program voltages, a plurality of pass voltages, a plurality of select read voltages, and a plurality of unselect read voltages.

To generate a plurality of operating voltages Vop having various voltage levels, the voltage generator 122 may include a plurality of pumping capacitors which receive the internal power voltage. The voltage generator 122 may generate the plurality of operating voltages Vop by selectively enabling the plurality of pumping capacitors under the control of the control logic 130. The plurality of operating voltages generated by the voltage generator 122 may be supplied to the memory cell array 110 through the address decoder 121.

The read/write circuit 123 may include first to mth page buffers PB1 to PBm. The first to mth page buffers PB1 to PBm may be connected to the memory cell array 110 respectively through first to mth bit lines BL1 to BLm. The first to mth page buffers PB1 to PBm may operate under the control of the control logic 130.

The first to mth page buffers PB 1 to PBm may communicate data DATA with the data input/output circuit 124. In a program operation, the first to mth page buffers PB1 to PBm may receive data DATA to be stored through the data input/output circuit 124 and data lines DL.

In a program operation, the first to mth page buffers PB 1 to PBm may transfer to selected memory cells data DATA received through the data input/output circuit 124 through the bit lines BL1 to BLm when a program voltage is applied to the selected word line. Memory cells of a selected page may be programmed according to the transferred data DATA. A threshold voltage of a memory cell connected to a bit line through which a program allow voltage (e.g., a ground voltage) is applied may increase. A threshold voltage of a memory cell connected to a bit line through which a program inhibit voltage (e.g., a power voltage) is applied may be maintained. In a program verify operation, the first to mth page buffers PB1 to PBm may read from the memory cells data DATA stored in the selected memory cells through the bit lines BL1 to BLm.

In a read operation, the read/write circuit 123 may read data DATA from memory cells of a selected page through the bit lines BL1 to BLm, and store the read data DATA in the first to mth page buffers PB 1 to PBm.

In an erase operation, the read/write circuit 123 may float the bit lines BL1 to BLm. In an embodiment, the read/write circuit 123 may include a column select circuit.

The data input/output circuit 124 may be connected to the first to mth page buffers PB1 to PBm through the data lines DL. The data input/output circuit 124 may operate under the control of the control logic 130.

The data input/output circuit 124 may include a plurality of input/output buffers (not shown) which receive input data DATA. In a program operation, the data input/output circuit 124 may receive data DATA to be stored from an external controller (not shown). In a read operation, the data input/output circuit 124 may output, to the external controller, data DATA transferred from the first to mth page buffers PB 1 to PBm included in the read/write circuit 123.

In a read operation or verify operation, the sensing circuit 125 may generate a reference current in response to an allow bit VRYBIT generated by the control logic 130, and output to the control logic 130 a pass or fail signal PASS/FAIL by comparing a sensing voltage VPB received from the read/write circuit 123 with a reference voltage generated by the reference current.

The control logic 130 may be connected to the address decoder 121, the voltage generator 122, the read/write circuit 123, the data input/output circuit 124, and the sensing circuit 125. The control logic 130 may control a general operation of the memory device 100. The control logic 130 may operate in response to a command CMD transferred from an external device.

The control logic 130 may control the peripheral circuit 120 by generating several signals in response to a command CMD and an address ADDR. For example, the control logic 130 may generate the operation signal OPSIG, the address ADDR, a read/write circuit control signal PBSIGNALS, and the allow bit VRYBIT in response to the command CMD and the address ADDR. The control logic 130 may output the operation signal OPSIG to the voltage generator 122, output the address ADDR to the address decoder 121, output the read/write circuit control signal PBSIGNALS to the read/write circuit 123, and output the allow bit VRYBIT to the sensing circuit 125. Also, the control logic 130 may determine whether the verify operation has passed or failed in response to the pass or fail signal PASS/FAIL output by the sensing circuit 125.

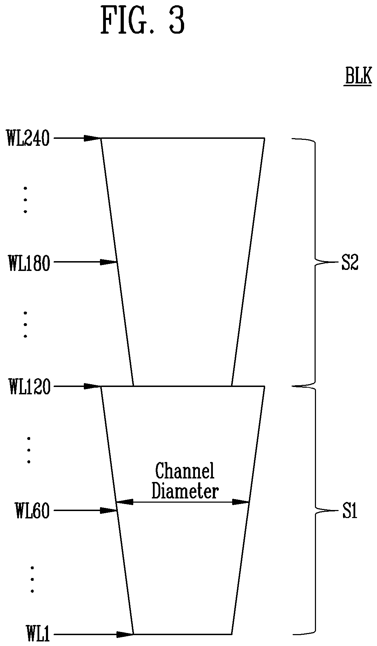

FIG. 3 is a diagram illustrating a memory block and positions of word lines in accordance with an embodiment of the present disclosure.

Referring to FIG. 3, a memory block BLK may include a plurality of sub-blocks S 1 and S2 which are stacked in a 3D structure. Each of the plurality of sub-blocks S 1 and S2 may include at least one word line. For example, a first sub-block S1 may include first to one hundred and twentieth word lines WL1 to WL120. A second sub-block S2 may include one hundred and twenty-first to two hundred and fortieth word lines WL121 to WL240. The number of word lines included in the memory block BLK is not limited to this embodiment. Memory cells connected to the same word line may constitute one physical page.

A stress level of each physical page may be individually determined according to a test result in a manufacturing process.

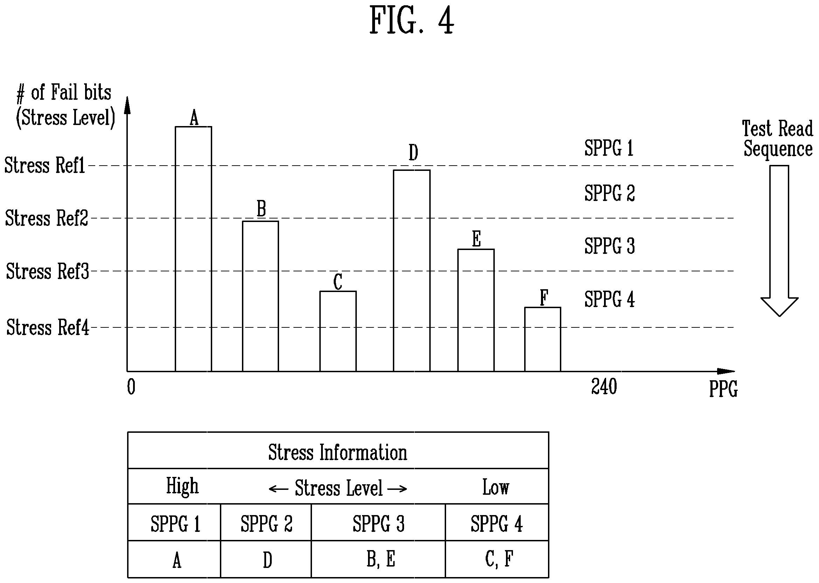

FIG. 4 is a diagram illustrating a stress physical page group and stress information in accordance with an embodiment of the present disclosure.

A stress physical page group may be determined according to a stress level of each physical page weak to read disturb, which is tested in a manufacturing process of the memory device. In an embodiment, a stress level may be determined based on a physical position of each of a plurality of physical pages included in a memory block. This is because, according to the physical positions of physical pages, characteristics of memory cells are different from each other, and influences given by the read disturb are different from each other.

In FIG. 4, the plurality of physical pages included in the memory block may be grouped into at least one stress physical page group. The number of stress physical page groups included in the memory block may be at least one. The number of physical pages included in each stress physical page group may be at least one. In an embodiment, numbers of stress physical page groups included in respective memory blocks may be the same. In an embodiment, the numbers of stress physical page groups included in the respective memory blocks may be different from each other for each memory block. In an embodiment, numbers of physical pages included in respective stress physical page groups may be the same. In an embodiment, the numbers of physical pages included in the respective stress physical page groups may be different from each other for each stress physical page group. At least two stress physical page groups among a plurality of stress physical page groups may include physical pages of which numbers are different from each other.

For example, a memory block may include a plurality of physical pages. The plurality of physical pages may include memory cells connected to the first to the two hundred and fortieth word lines WL1 to WL240. The plurality of physical pages may be grouped into first to fourth stress physical page groups SPPG1 to SPPG4. In a test in the manufacturing process, physical pages A having a fail bit detection number (hereinafter, referred to a stress level) which exceeds a first stress reference Stress Ref1 may be set to a first stress physical page group SPPG1. Physical pages D having a stress level which is lower than the first stress reference Stress Ref1 and is higher than a second stress reference Stress Ref2 may be set to a second stress physical page group SPPG2. Physical pages B and E having a stress level which is lower than the second stress reference Stress Ref2 and is higher than a third stress reference Stress Ref3 may be set to a third stress physical page group SPPG3. Physical pages C and F having a stress level which is lower than the third stress reference Stress Ref3 and is higher than a fourth stress reference Stress Ref4 may be set to a fourth stress physical page group SPPG4.

A test read operation may be individually performed on each stress physical page group. The test read operation may be sequentially performed in an order in which the stress level is high. For example, the test read operation may be individually performed in an order from the first stress physical page group SPPG1 to the fourth stress physical page group SPPG4.

Stress information may include a plurality of stress physical page groups obtained by grouping a plurality of physical pages included in a memory block according to a stress level of each of the plurality of physical pages weak to the read disturb.

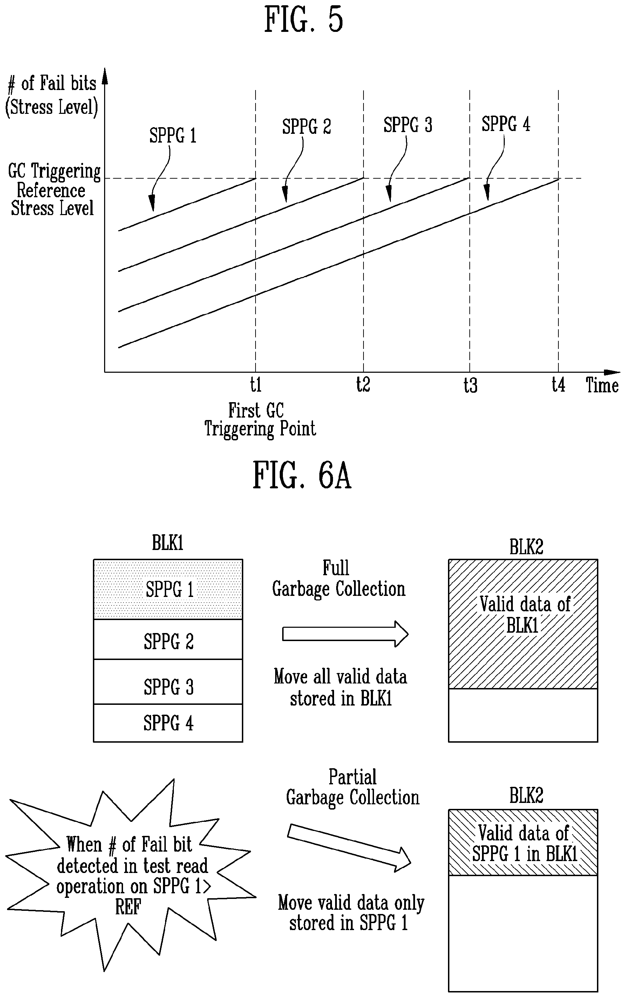

FIG. 5 is a diagram illustrating an accessible period for each stress physical page group.

Referring to FIGS. 4 and 5, a memory block may include first to fourth stress physical page group SPPG1 to SPPG4.

At time t1, the first stress physical page group SPPG1 having a highest stress level may reach a garbage collection triggering reference stress level, and a partial garbage collection operation of moving, to another memory block, valid data stored in the first stress physical page group SPPG1 may be performed. In an embodiment, the garbage collection triggering reference stress level is the same for each stress physical page group. In an embodiment, the garbage collection triggering reference stress level may vary for each stress physical page group. The second to fourth stress physical page groups SPPG2 to SPPG4 which do not reach the garbage collection triggering reference stress level may be accessible. That is, when the storage device receives an access request from the host for the second to fourth stress physical page groups SPPG2 to SPPG4, the storage device may provide the host with a response to the access request.

At time t2, the second stress physical page group SPPG2 having a second highest stress level may reach the garbage collection triggering reference stress level, and a partial garbage collection operation of moving, to another memory block, valid data stored in the second stress physical page group SPPG2 may be performed. At the time t2, the third and fourth stress physical page groups SPPG3 and SPPG4, which do not reach the garbage collection triggering reference stress level, may be accessible.

At time t3, the third stress physical page group SPPG3 having a third highest stress level may reach the garbage collection triggering reference stress level, and a partial garbage collection operation of moving, to another memory block, valid data stored in the third stress physical page group SPPG3 may be performed. The fourth stress physical page group SPPG4 which does not reach the garbage collection triggering reference stress level may be accessible.

At time t4, the fourth stress physical page group SPPG4 having a fourth highest stress level may reach the garbage collection triggering reference stress level, and a partial garbage collection operation of moving, to another memory block, valid data stored in the fourth stress physical page group SPPG4 may be performed. At the time t4, a garbage collection operation on all stress physical page groups in the memory block may be completed.

FIG. 6A is a diagram illustrating a full garbage collection operation and a partial garbage collection operation in accordance with an embodiment of the present disclosure.

Referring to FIG. 6A, a first memory block BLK1 may include first to fourth stress physical page groups SPPG1 to SPPG4.

In the case of a full garbage collection operation, when the number of fail bits detected in a test read operation on the first stress physical page group SPPG1 exceeds a reference value, all valid data stored in the first memory block BLK1 including the first stress physical page group SPPG1 may be moved to a second memory block BLK2.

In the case of a partial garbage collection operation, when the number of fail bits detected in the test read operation on the first stress physical page group SPPG1 exceeds the reference value, only valid data stored in the first stress physical page group SPPG1 may be moved to the second memory block BLK2.

As compared with the full garbage collection operation, in the case of the partial garbage collection operation, only the valid data stored in the first stress physical page group SPPG1 is moved to the second memory block BLK2, and hence the triggering time of a garbage collection operation can be shortened.

In addition, in the case of the second to fourth stress physical page groups SPPG2 to SPPG4, the second to fourth stress physical page groups SPPG2 to SPPG4 are accessible. Hence, an unnecessary write operation due to garbage collection can be reduced and the Write Amplification Index (WAI) can be improved.

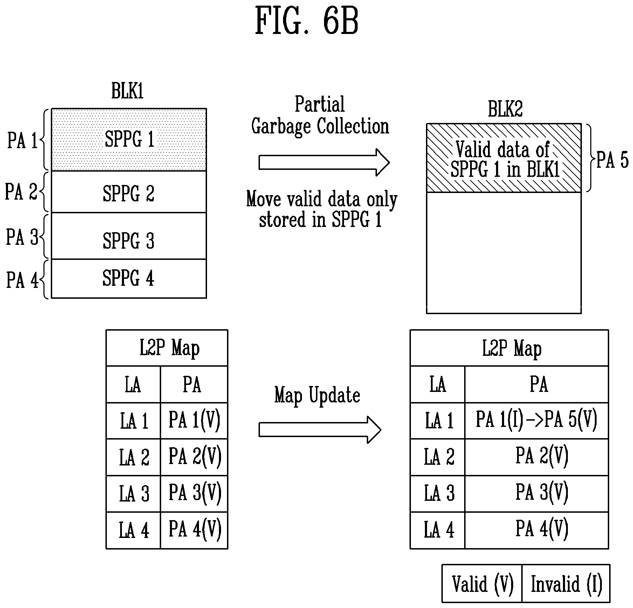

FIG. 6B is a diagram illustrating a map update in the partial garbage collection operation in accordance with an embodiment of the present disclosure.

Referring to FIG. 6B, physical addresses of the first to fourth stress physical page groups SPPG1 to SPPG4 included in the first memory block BLK1 may be first to fourth physical addresses PA 1 to PA 4, respectively. A logical address to physical address map L2P Map may include mapping information between first to fourth logical addresses LA 1 to LA 4 and the first to fourth physical addresses PA 1 to PA 4. Physical pages corresponding to the first to fourth physical addresses PA 1 to PA 4 may be valid pages in which valid data is stored.

When as described with reference to FIG. 6A, the partial garbage collection operation of moving, to the second memory block BLK2, only the valid data stored in the first stress physical page group SPPG1 is performed, a portion of the logical address to physical address map L2P Map may be updated.

For example, a physical address mapped to the first logical address LA 1 may be changed from the first physical address PA 1 of the first memory block BLK1 to a fifth physical address PA 5 of the second memory block BLK2. Data stored in physical pages corresponding to the first physical address PA 1 may be invalidated. Data stored in physical pages corresponding to the fifth physical address PA 5 may be validated.

Therefore, when the storage device receives an access request for the first logical address LA 1 after the partial garbage collection operation is performed on only the first stress physical page group SPPG1, the storage device may access the second memory block BLK2 with reference to the fifth physical address PA 5. When the storage device receives an access request for the second to fourth logical addresses LA 2 to LA 4, the storage device may access the first memory block BLK1 with reference to the second to fourth physical addresses PA 2 to PA 4.

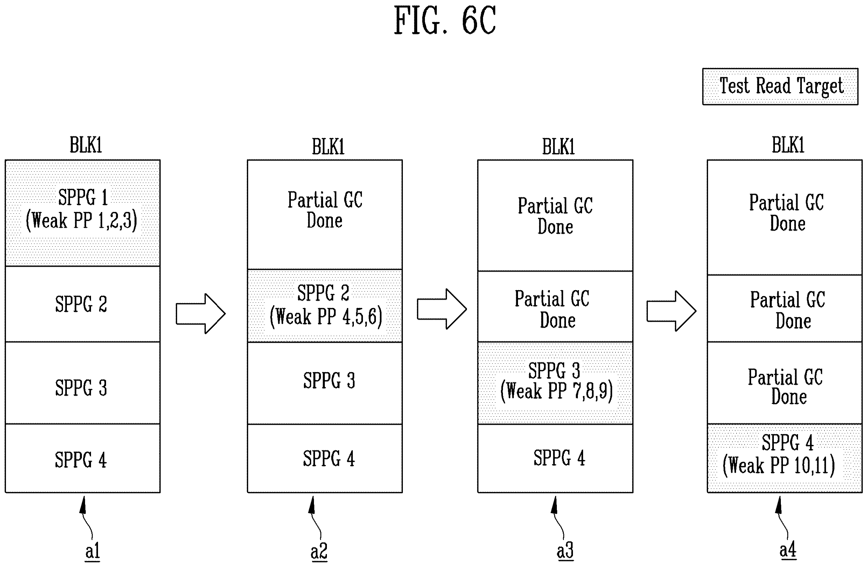

FIG. 6C is a diagram illustrating stress physical page groups on which test read is performed and the order in which the test read is performed.

Referring to FIG. 6C, the first memory block BLK1 may include first to fourth stress physical page groups SPPG1 to SPPG4. A stress level is high in an order of the first to fourth stress physical page groups SPPG1 to SPPG4. A stress physical page group may include at least one weak physical page. The weak physical page may be a physical page which is weakest to read disturb in a test in a manufacturing process of the memory device, among a plurality of physical pages included in each stress physical page group. The physical pages included in each stress physical page group may have similar read disturb weak characteristics.

For example, the first stress physical page group SPPG1 may include first to third weak physical pages Weak PP 1 to Weak PP 3. The second stress physical page group SPPG2 may include fourth to sixth weak physical pages Weak PP 4 to Weak PP 6. The third stress physical page group SPPG3 may include seventh to ninth weak physical pages Weak PP 7 to Weak PP 9. The fourth stress physical page group SPPG4 may include tenth and eleventh weak physical pages Weak PP 10 and Weak PP 11.

A test read operation may be individually performed on each stress physical page group in an order in which the stress level is high. For example, at time a1, a read count of a memory block may reach a first test read count, and the test read operation may be performed on a target stress physical page group of the first memory block BLK1. The first stress physical page group SPPG1 having a highest stress level among the plurality of stress physical page groups included in the first memory block BLK1 may be selected as a target stress physical page group. The test read operation may be performed on each of the first to third weak physical pages Weak PP 1 to Weak PP 3 which are weakest to the read disturb, among a plurality of physical pages included in the first stress physical page group SPPG1. When the number of fail bits detected in each test read operation exceeds the reference value, a partial garbage collection operation of moving, to another memory block, valid data stored in the first stress physical page group SPPG1 may be performed. A logical address of valid data stored in the first stress physical page group SPPG1 may be re-mapped to a physical address of the another memory block, and a physical address of the first stress physical page group SPPG1 may be invalidated.

At time a2, after the partial garbage collection operation on the first stress physical page group SPPG1 is performed, the second stress physical page group SPPG2 having a second highest stress level among the plurality of stress physical page groups included in the first memory block BLK1 may be selected as a target stress physical page group. A test read operation may be performed on the second stress physical page group SPPG2 selected as the target stress physical page group. The test read operation may be performed on each of the fourth to sixth weak physical pages Weak PP 4 to Weak PP 6 included in the second stress physical page group SPPG2. When the number of fail bits detected in each test read operation exceeds the reference value, a partial garbage collection operation of moving, to another memory block, valid data stored in the second stress physical page group SPPG2 may be performed. A logical address of valid data stored in the second stress physical page group SPPG2 may be re-mapped to a physical address of the another memory block, and a physical address of the second stress physical page group SPPG2 may be invalidated.

After the partial garbage collection operation on the second stress physical page group SPPG2 is performed, the third stress physical page group SPPG3 having a third highest stress level among the plurality of stress physical page groups included in the first memory block BLK1 may be selected as a target stress physical page group. A test read operation may be performed on the third stress physical page group SPPG3 selected as the target stress physical page group. The test read operation may be performed on each of the seventh to ninth weak physical pages Weak PP 7 to Weak PP 9 included in the third stress physical page group SPPG3. When the number of fail bits detected in each test read operation is the reference value or less, any test read operation on the first memory block BLK1 may not be performed until time a3 at which the read count of the memory block reaches a second test read count.

At the time a3, the read count of the memory block may reach the second test read count, and a test read operation may be performed on a target stress physical page group of the first memory block BLK1. The third stress physical page group SPPG3 having a third highest stress level among the plurality of stress physical page groups included in the first memory block BLK1 may be selected as a target stress physical page group. The third stress physical page group SPPG3 may be a stress physical page group having a highest stress level among a plurality of stress physical page groups on which any partial garbage collection operation is not performed in the first memory block BLK1 at the time a3. A test read operation may be performed on the third stress physical page group SPPG3 selected as the target stress physical page group. The test read operation may be performed on each of the seventh to ninth weak physical pages Weak PP 7 to Weak PP 9 included in the third stress physical page group SPPG3. When the number of fail bits detected in each test read operation exceeds the reference value, a partial garbage collection operation of moving, to another memory block, valid data stored in the third stress physical page group SPPG3 may be performed. A logical address of valid data stored in the third stress physical page group SPPG3 may be re-mapped to a physical address of the another memory block, and a physical address of the third stress physical page group SPPG3 may be invalidated.

After the partial garbage collection operation on the third stress physical page group SPPG3 is performed, the fourth stress physical page group SPPG4 having a fourth highest stress level among the plurality of stress physical page groups included in the first memory block BLK1 may be selected as a target stress physical page group. A test read operation may be performed on the fourth stress physical page group SPPG4 selected as the target stress physical page group. The test read operation may be performed on each of the tenth and eleventh weak physical pages Weak PP 10 and Weak PP 11 included in the fourth stress physical page group SPPG4. When the number of fail bits detected in each test read operation is the reference value or less, any test read operation on the first memory block BLK1 may not be performed until time a4 at which the read count of the memory block reaches a third test read count.

At the time a4, the read count of the memory block may reach the third test read count, and a test read operation may be performed on a target stress physical page group of the first memory block BLK1. The fourth stress physical page group SPPG4 may be selected as a target stress physical page group. A test read operation may be performed on the fourth stress physical page group SPPG4 selected as the target stress physical page group. The test read operation may be performed on each of the tenth and eleventh weak physical pages Weak PP 10 and Weak PP 11 included in the fourth stress physical page group SPPG4. When the number of fail bits detected in each test read operation exceeds the reference value, a partial garbage collection operation of moving, to another memory block, valid data stored in the fourth stress physical page group SPPG4 may be performed. A logical address of valid data stored in the fourth stress physical page group SPPG4 may be re-mapped to a physical address of the another memory block, and a physical address of the fourth stress physical page group SPPG4 may be invalidated.

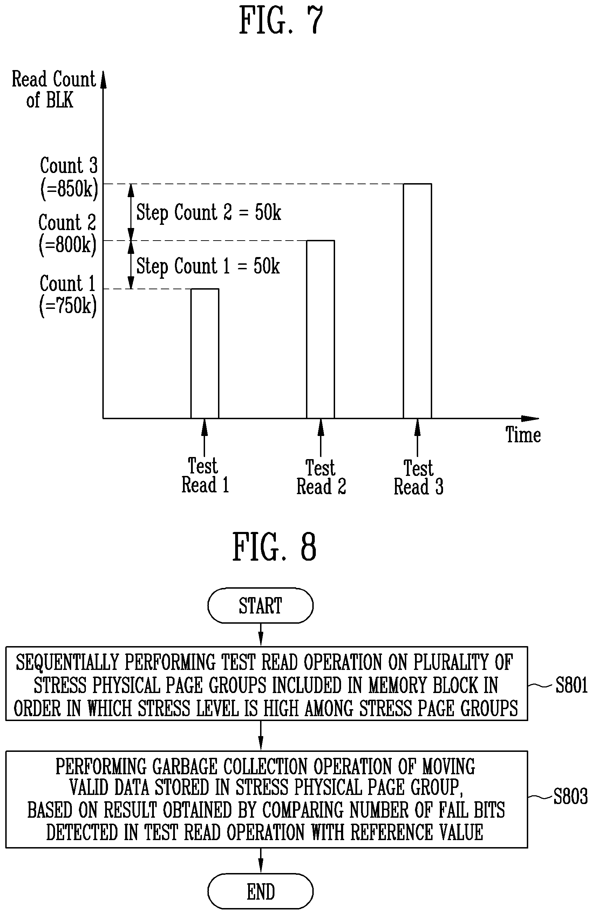

FIG. 7 is a diagram illustrating a test read performance time in accordance with an embodiment of the present disclosure.

Referring to FIG. 7, a test read operation may be performed when a read count of a memory block reaches a predetermined test read count. Test read count values may be variously set according to performance, operation environments, or lifetime of the memory device.

For example, when the read count of the memory block reaches a first test read count Count 1, a first test read operation Test Read 1 may be performed. When the read count of the memory block reaches a second test read count Count 2, a second test read operation Test Read 2 may be performed. When the read count of the memory block reaches a third test read count Count 3, a third test read operation Test Read 3 may be performed. The first test read count Count 1 may be set to 750k (i.e., 750,000), the second test read count Count 2 may be set to 800k, and the third test read count Count 3 may be set to 850k. A first step count Step Count 1 as a difference between the first test read count Count 1 and the second test read count Count 2 may be 50k. A second step count Step Count 2 as a difference between the second test read count Count 2 and the third test read count Count 3 may be 50k. Each step count may be set to the same value. In another embodiment, the step counts may be set different from each other.

FIG. 8 is a flowchart illustrating an operation of the storage device in accordance with an embodiment of the present disclosure.

Referring to FIG. 8, in S801, the storage device may sequentially perform a test read operation on a plurality of stress physical page groups included in a memory block, in an order in which the stress level is high among the stress physical page groups. Specifically, the storage device may perform a test read operation on at least one weak physical page in a stress physical page group.

In S803, the storage device may perform a garbage collection operation of moving valid data stored in a stress physical page group, based on a result obtained by comparing the number of fail bits detected in the test read operation with a reference value. For example, the storage device may move, to another memory block, valid data stored in a stress physical page group in which the number of fail bits exceeds the reference value.

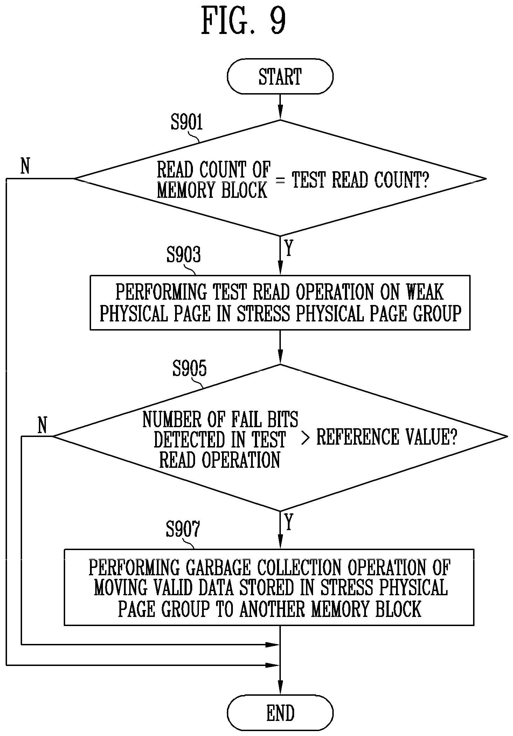

FIG. 9 is a flowchart illustrating an operation of the storage device in accordance with an embodiment of the present disclosure.

Referring to FIG. 9, in S901, the storage device may decide whether a read count of a memory block is equal to a predetermined test read count. The storage device may proceed to S903 when the read count is equal to the test read count as a decision result (S901, Y), and end the operation when the read count is different from the test read count (S901, N).

In the S903, the storage device may perform a test read operation on a weak physical page in a stress physical page group. The weak physical page may be a physical page which is weakest to read disturb in a test in a manufacturing process of the memory device, among a plurality of physical pages included the stress physical page group.

In S905, the storage device may decide whether the number of fail bits detected in the test read operation exceeds a reference value. The storage device may proceed to S907 when the number of fail bits exceeds the reference value (S905, Y), and end the operation when the number of fail bits is the reference value or less (S905, N).

In the S907, the storage device may perform a garbage collection operation of moving, to another memory block, valid data stored in the stress physical page group. An access to a stress physical page group on which any garbage collection operation is not performed in the memory block may be possible.

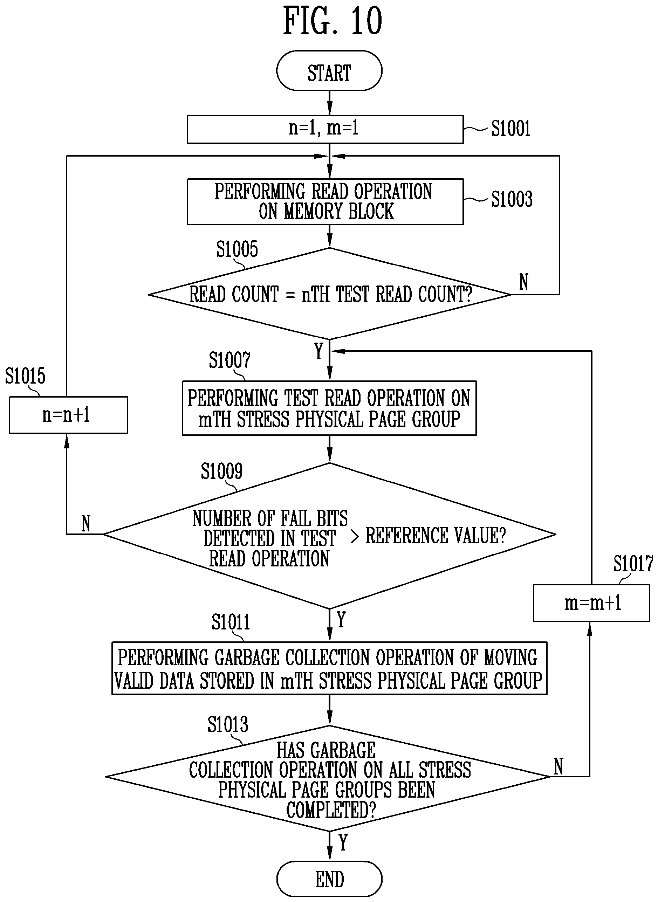

FIG. 10 is a flowchart illustrating an operation of the storage device in accordance with an embodiment of the present disclosure.

Referring to FIG. 10, in S1001, each of n and m may be set to 1 (n=1 and m=1).

In S 1003, the storage device may perform a read operation on a memory block.

In S 1005, the storage device may decide whether a read count of the memory block is equal to an nth test read count. The storage device may proceed to S1007 when the read count is equal to the nth test read count as a decision result (S1005, Y), and proceed to S1003 when the read count is different from the nth test read count as a decision result (S1005, N).

In the S1007, the storage device may perform a test read operation on an mth stress physical page group. The mth stress physical page group may be a physical page group having an mth highest stress level, among a plurality of stress physical page groups included in the memory block.

In S1009, the storage device may decide whether the number of fail bits detected in the test read operation exceeds a reference value. The storage device may proceed to S1011 when the number of fail bits exceeds the reference value as a decision result (S1009, Y), and proceed to S1015 when the number of fail bits is the reference value or less as a decision result (S1009, N).

In the S1011, the storage device may perform a garbage collection operation of moving valid data stored in the mth stress physical page group to another memory block. The garbage collection operation performed on the mth stress physical page group may be a partial garbage collection operation.

In S1013, the storage device may decide whether a garbage collection operation on all stress physical page groups included in the memory block has been completed. The storage device may end the operation when the garbage collection operation on all stress physical page groups is completed (S1013, Y), and proceed to S1017 when at least one stress physical page group on which the garbage collection operation is not completed exists (S1013, N).

In the S1015, n may be increased by 1 (i.e., n=n+1).

In the S1017, m may be increased by 1 (i.e., m=m+1).

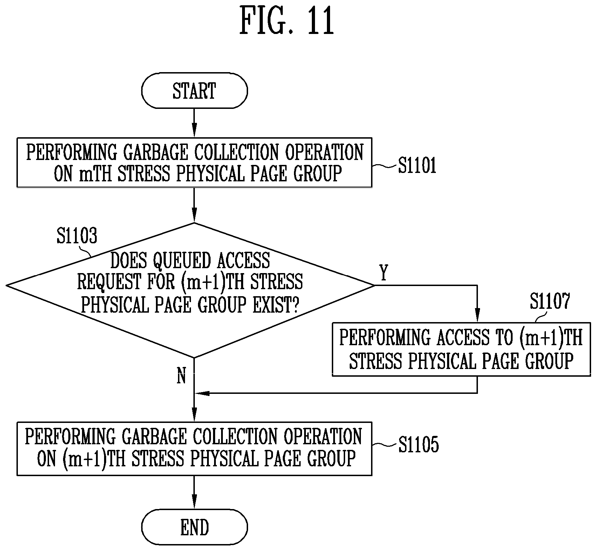

FIG. 11 is a flowchart illustrating an operation of the storage device in accordance with an embodiment of the present disclosure.

Referring to FIG. 11, in S1101, the storage device may perform a garbage collection operation on an mth, where m is a natural number of 1 or more, stress physical page group.

In S1103, the storage device may decide whether a queued access request for an (m+1)th stress physical page group exists. The storage device may proceed to S1107 when the queued access request exists as a decision result (S1103, Y), and proceed to S1105 when the queued access request does not exist as a decision result (S1103, N).

In the S1105, the storage device may perform a garbage collection operation on the (m+1)th stress physical page group.

In the S1107, the storage device may perform an access to the (m+1)th stress physical page group.

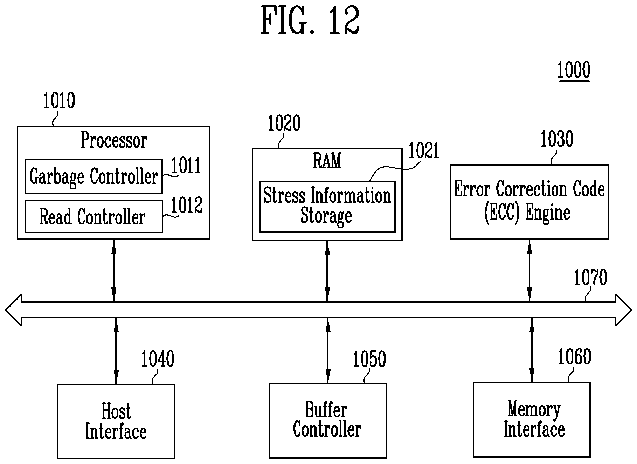

FIG. 12 is a diagram illustrating another embodiment of the memory controller shown in FIG. 1.

Referring to FIG. 12, a memory controller 1000 may be connected to the host and the memory device. The memory controller 1000 may access the memory device in response to a request from the host.

The memory controller 1000 shown in FIG. 12 may be the memory controller 200 shown in FIG. 1.

The memory controller 1000 may control write, read, erase, and background operations of the memory device. The memory controller 1000 may provide an interface between the memory device and the host. The memory controller 1000 may drive firmware for controlling the memory device.

The memory controller 1000 may include a processor 1010, a random access memory (RAM) 1020, an Error Correction Code (ECC) engine 1030, a host interface 1040, a buffer controller 1050, a memory interface 1060, and a bus 1070.

The bus 1070 may provide a channel between components of the memory controller 1000.

The processor 1010 may control a general operation of the memory controller 1000, and perform a logical operation. The processor 1010 may communicate with the external host through the host interface 1040, and communicate with the memory device through the memory interface 1060. Also, the processor 1010 may communicate with the RAM 1020 through the buffer controller 1050. The processor 1010 may control an operation of the memory device, using the RAM 1020 as a working memory, a cache memory, or a buffer memory.

The processor 1010 may translate a Logical Block Address (LBA) provided by the host into a Physical Block Address (PBA). A Flash Translation Layer (FTL) may receive an LBA, to translate the LBA into a PBA, using a mapping table.

When the memory device is a nonvolatile memory, the processor 1010 may randomize data received from the host. The randomized data may be provided to the memory device to be programmed.

The processor 1010 may derandomize data received from the memory device in a read operation. For example, the processor 1010 may derandomize data received from the memory device, using a derandomizing seed, and output the derandomized data to the host.

In an embodiment, the processor 1010 may perform randomizing and derandomizing by driving software or firmware.

In an embodiment, the processor 1010 may include a read controller 1012 and a garbage controller 1011 as described with reference to FIG. 1. The read controller 1012 may perform a test read operation on a stress physical page group included in a memory block, based on stress information, and detect fail bits from a result of the test read operation.

When the number of the fail bits detected in the test read operation exceeds a reference value, the garbage controller 1011 may perform a partial garbage collection operation of moving valid data stored in the stress physical page group to another memory block.

The RAM 1020 is a volatile memory, and may be used as a working memory, a cache memory, or a buffer memory of the processor 1010. The RAM 1020 may store codes and commands, which are executed by the processor 1010. The RAM 1020 may store data processed by the processor 1010. The RAM 1020 may include a Static RAM (SRAM) or a Dynamic RAM (DRAM).

In an embodiment, the RAM 1020 may include a stress information storage 1021 as described with reference to FIG. 1. The stress information storage 1021 may store stress information including a stress physical page group included in a memory block and a stress level of the stress physical page group.

The ECC engine 1030 may perform error correction. The ECC engine 1030 may perform Error Correction Code (ECC) encoding on data to be written in the memory device through the memory interface 1060. The ECC encoded data may be transferred to the memory device through the memory interface 1060. The ECC engine 1030 may perform ECC decoding on data received from the memory device through the memory interface 1060. The ECC engine 1030 may be included in the memory interface 1060 as a component of the memory interface 1060.

The host interface 1040 may communicate with the external host under the control of the processor 1010. The host interface 1040 may communicate with the host, using at least one of various communication standards or protocols, such as a Universal Serial bus (USB), a Serial AT Attachment (SATA), a Serial Attached SCSI (SAS), a Small Computer System Interface (SCSI), a Peripheral Component Interconnection (PCI), a PCI express (PCIe), a NonVolatile Memory Express (NVMe), and a Universal Flash Storage (UFS).

The buffer controller 1050 may control the RAM 1020 under the control of the processor 1010. The memory interface 1060 may communicate a command, an address, and data with the memory device through the channel under the control of the processor 1010.

The processor 1010 may control an operation of the memory controller 1000 by using codes. The processor 1010 may load codes from a nonvolatile memory device (e.g., a read only memory (ROM)) provided in the memory controller 1000. In another example, the processor 1010 may load codes from the memory device through the memory interface 1060.

The bus 1070 of the memory controller 1000 may be divided into a control bus and a data bus. The data bus may be configured to transmit data in the memory controller 1000, and the control bus may be configured to transmit control information such as a command and an address in the memory controller 1000. The data bus and the control bus are separated from each other, and may not interfere or influence with each other. The data bus may be connected to the host interface 1040, the buffer controller 1050, the ECC engine 1030, and the memory interface 1060. The control bus may be connected to the host interface 1040, the processor 1010, the buffer controller 1050, and the memory interface 1060.

In accordance with embodiments of the present disclosure, there can be provided a storage device and an operating method thereof, in which a test read operation is performed on only a stress physical page group weak to read disturb in a memory block, and a garbage collection operation is performed on the stress physical page group according to a result of the test read operation.

While the embodiments of the present disclosure have been shown and described with reference to certain embodiments thereof, it will be understood by those skilled in the art that various changes in form and details may be made therein without departing from the spirit and scope of the present disclosure as defined by the appended claims and their equivalents. Therefore, the scope of the present disclosure should not be limited to the above-described embodiments but should be determined by not only the appended claims but also the equivalents thereof.

In the above-described embodiments, all operations may be selectively performed or part of the operations may be omitted. In each embodiment, the operations are not necessarily performed in accordance with the described order and may be rearranged. The embodiments disclosed in this specification and drawings are only examples to facilitate an understanding of the present disclosure, and the present disclosure is not limited thereto. That is, it should be apparent to those skilled in the art that various modifications can be made based on the technological scope of the present disclosure.

The embodiments of the present disclosure have been described in the drawings and specification. Although specific terminologies are used here, those are only to describe the embodiments of the present disclosure. Therefore, the present disclosure is not restricted to the above-described embodiments and many variations are possible within the spirit and scope of the present disclosure. It should be apparent to those skilled in the art that various modifications can be made based on the technological scope of the present disclosure in addition to the embodiments disclosed herein. Furthermore, the embodiments may be combined to form additional embodiments.

## Claims

1. A storage device comprising:
a memory device including a memory block including a plurality of physical pages; and
a memory controller configured to group the plurality of physical pages into a plurality of stress physical page groups according to a stress level of each of the plurality of physical pages, the stress level associated with read disturb, and perform a garbage collection operation on each of the plurality of stress physical page groups, based on the stress level.

2. The storage device of claim 1, wherein the memory controller performs a test read operation on at least one weak physical page in a target stress physical page group among the plurality of stress physical page groups, and performs the garbage collection operation of moving, to another memory block, valid data stored in the target stress physical page group when a number of fail bits detected in the test read operation exceeds a reference value.

3. The storage device of claim 2, wherein the memory controller performs a garbage collection operation on each of the plurality of stress physical page groups in an order in which the stress level is from high to low, and
wherein the memory controller:
selects, as the target stress physical page group, a first stress physical page group having the highest stress level among the plurality of stress physical page groups, and
selects, as the target stress physical page group, a second stress physical page group having the second highest stress level among the plurality of stress physical page groups when the garbage collection operation on the first stress physical page group is performed.

4. The storage device of claim 3, wherein the memory controller accesses the second stress physical page group when the memory controller receives, from a host, an access request for the second stress physical page group before the garbage collection operation on the second stress physical page group is performed after the garbage collection operation on the first stress physical page group is performed.

5. The storage device of claim 2, wherein the at least one weak physical page includes a physical page weakest to the read disturb among a plurality of physical pages included in the target stress physical page group, and is predetermined in a manufacturing process of the memory device to be set in firmware.

6. The storage device of claim 1, wherein the memory controller performs a test read operation on a target stress physical page group among the plurality of stress physical page groups when a read count of the memory block reaches a first test read count, and re-performs the test read operation on the target stress physical page group when a number of fail bits detected in the test read operation is a reference value or less and when the read count of the memory block reaches a second test read count.

7. The storage device of claim 1, wherein the plurality of stress physical page groups are predetermined in a manufacturing process of the memory device to be set in firmware.

8. The storage device of claim 1, wherein a number of the plurality of stress physical page groups included in the memory block is equal to a number of stress physical page groups included in another memory block different from the memory block.

9. The storage device of claim 6, wherein the first test read count is greater than a difference between the first test read count and the second test read count.

10. The storage device of claim 1, wherein at least two stress physical page groups among the plurality of stress physical page groups include different numbers of physical pages.

11. The storage device of claim 6, wherein the memory controller repeatedly performs the test read operation on the plurality of stress physical page groups until a garbage collection operation on each of the plurality of stress physical page groups is completed.

12. A method of operating a storage device, the method comprising:
grouping a plurality of physical pages included in a memory block of a memory device of the storage device into a plurality of stress physical page groups according to a stress level of each of the plurality of physical pages, the stress level associated with read disturb;
selecting a target stress physical page group among the plurality of stress physical page groups, based on the stress level;
performing a first garbage collection operation on the target stress physical page group;
receiving, from a host, an access request after the first garbage collection operation is performed, the access request being for the other stress physical page group different from the target stress physical page group among the plurality of stress physical page groups; and
performing a second garbage collection operation on the other stress physical page group after a response to the access request is transmitted to the host.

13. The method of claim 12, further comprising: performing a test read operation on at least one weak physical page in the target stress physical page group before the first garbage collection operation is performed,
wherein the performing the first garbage collection operation includes moving, to another memory block, valid data stored in the target stress physical page group when a number of fail bits detected in the test read operation exceeds a reference value.

14. The method of claim 13, wherein the performing of the test read operation includes:
performing the test read operation when a read count of the memory block reaches a first test read count; and
re-performing the test read operation when the number of fail bits is the reference value or less and when the read count reaches a second test read count greater than the first test read count.

15. The method of claim 13, wherein the at least one weak physical page includes a physical page weakest to the read disturb among a plurality of physical pages included in the target stress physical page group, and is predetermined in a manufacturing process of the memory device.

16. The method of claim 12, wherein the selecting of the target stress physical page group includes:
selecting, as the target stress physical page group, a first stress physical page group having the highest stress level among the plurality of stress physical page groups; and
selecting, as the target stress physical page group, a second stress physical page group having the second highest stress level among the plurality of stress physical page groups when a garbage collection operation on the first stress physical page group is performed.

17. A memory controller comprising:
a stress information storage configured to store stress information on a plurality of stress physical page groups obtained by grouping a plurality of physical pages included in a memory block according to a stress level of each of the plurality of physical pages, the stress level associated with read disturb;
a read controller configured to perform a test read operation on at least one weak physical page in a target stress physical page group among the plurality of stress physical page groups; and
a garbage controller configured to perform a garbage collection operation on each of the plurality of stress physical page groups, based on the stress level.

18. The memory controller of claim 17, wherein the garbage controller performs the garbage collection operation of moving, to another memory block, valid data stored in the target stress physical page group when a number of fail bits detected in the test read operation exceeds a reference value.

19. The memory controller of claim 17, wherein the read controller selects, as the target stress physical page group, a first stress physical page group having the highest stress level among the plurality of stress physical page groups, and selects, as the target stress physical page group, a second stress physical page group having the second highest stress level among the plurality of stress physical page groups when the garbage collection operation on the first stress physical page group is performed.

20. The memory controller of claim 17, wherein the read controller performs a test read operation on a target stress physical page group among the plurality of stress physical page groups when a read count of the memory block reaches a first test read count, and re-performs the test read operation on the target stress physical page group when a number of fail bits detected in the test read operation is a reference value or less and when the read count of the memory block reaches a second test read count.
